# EUROPEAN PATENT APPLICATION

(11) **EP 0 924 755 A2**
(43) Date of publication of application: **23.06.1999**
(21) Application number: 98309792.4
(22) Date of filing: 30.11.1998
(51) Int. Cl.: H01L 21/48

(54) **Method of fabricating a multilayer circuit board**

(30) Priority: 19.12.1997 US 994237
(71) Applicant: CTS Corporation, Elkhart Indiana 46514-1899 (US)
(72) Inventor: Bloom, Terry R., Middlebury, IN 46540 (US); Stamm, Cathy, Elkhart, IN 46514 (US); Roberts, Mark, Elkhart, IN 46514 (US)
(74) Representative: Loven, Keith James

(57) **Abstract**

A multilayer circuit board includes a substrate (310), at least one layer of patterned conductive material (320, 340), and at least one layer of resistant dielectric material (332, 334, 336) bonded to the layer of conductive material and the substrate. A method for fabricating such a circuit board includes juxtaposing the dielectric material against the substrate, with the conductive material in between, subjecting the assembly to only one lamination, and co-firing the assembly. A moderating agent including material capable of softening and smoothing the dielectric material is used to assist it in bonding to the substrate.

## Description

### BACKGROUND OF THE INVENTION

### 1. Technical Field

This invention relates to the field of circuit boards. More specifically this invention relates to a method for fabricating multilayer circuit boards.

### 2. Background Art

Within the electronics industry, an increasingly competitive need exists to decrease the cost of electronic components. However, the decreased cost typically cannot result in lower quality components or fabrication processes that yield increased amounts of defective components. Further, an accompanying need exists to decrease the size of components to allow greater device density. Essentially, circuit boards include alternating layers of insulative materials and patterned conductive materials, wherein conductive layers are connected by vias formed through insulative layers. At times, the combination of alternating layers are in turn joined to a supporting substrate, for example, a substrate made from metal, ceramic, or some combination of such materials. Circuit boards are primarily designed to provide conductive interconnections between other electronic components, but may also integrate other devices such as inductors, capacitors, resistors, etc. directly into the circuit board. That is, a circuit board may be a complete electronic component or a plurality of diverse electronic components may be mounted to a circuit board to form a single unit.

Because circuit boards are so widely manufactured and used, even relatively small cost, yield, or reliability improvements can be key competitive advantages. One advantageous improvement is the use of dielectric tape in circuit boards. Dielectric tape is used as an insulative layer that includes vias formed in a section of tape. Layers of patterned conductive material are screen printed on the tape. By layering several such tapes and firing them to burn off any organic compounds, a hard ceramic multilayered circuit is formed, also known as LTCC or low temperature co-fired ceramics. Numerous methods currently exist for combining tape layers, however, each possesses limitations and disadvantages. Some such methods are disclosed in U.S. Patent No. 5,581,876 issued to Prabhu et al., U.S. Patent No. 5,277,724 issued to Prabhu, U.S. Patent No. 5,041,695 issued to Olenick et al., U.S. Patent No. 4,654,095 issued to Steinberg, and U.S. Patent No. 4,655,864 issued to Rellick, each of which is hereby incorporated by reference for their pertinent and supportive teachings.

One common process to form dielectric tape circuits is to form one layer at a time in a repetitive tape-on-substrate (TOS) process on top of a rigid substrate, also known as a tape-on-substrate process. In assembly, the tape-on-substrate process, first has any vias formed in a support substrate, such as a 96% alumina substrate, are filled with conductive material, dried, and fired. Second, patterned conductive layer(s) are applied, typically by screen printing, to the substrate to form traces or passive electrical components. The conductive layers are dried, and fired accordingly. Third, a single dielectric tape layer having vias, traces, and/or passive components formed thereon, is laminated to the substrate and co-fired. The tape would normally shrink during lamination and/or firing, but an adequate bond between the tape and substrate will yield a dielectric layer that conforms to the desired position and dimension. Finally, the process is repeated to add a second dielectric tape by filling vias, drying, firing applying a second conductive layer to the second tape, drying, firing, and thereby laminating the second dielectric layer to the first layer on the substrate, and co-firing. Subsequent repetition of the steps continues until the desired multilayer circuit board is obtained using this tape-on-substrate (TOS) approach. It is a disadvantage of the TOS process that multiple drying, firing, and lamination steps are required, yielding a relatively high processing time and cost.

For the tape to stick to a rigid substrate, like an alumina ceramic, it must contain a suitable amount of plasticizer to form a bond between the tape and substrate. Unfortunately, many of the best tapes do not contain sufficient quantities of those ingredients. Accordingly, such tapes cannot be used in a conventional tape-on-substrate process. One such dielectric tape is known as GREEN TAPE™ 951AT available from E. I. Du Pont de Nemours and Co. in Wilmington, DE.

Another method of forming circuits includes LTCC or low temperature co-fired ceramic circuit. This differs from TOS in that the tape layers are laminated and fired without a substrate. For example, first, any vias in each dielectric tape layer are filled with conductive material and dried. Second, any patterned conductive layer is applied and dried to each tape layer. Finally, the layers are stacked, laminated (applying pressure and low temperature), and fired to a high temperature to form the LTCC circuit. However, if fewer than about five dielectric tape layers, or less than about 15 to 25 mils thick, are used in the circuit assembly, then it generally will be too thin to prevent easy breakage of the circuit. Specifically, any bending of the layers would crack the assembly or break electrical connections in the circuit. To avoid this minimum thickness problem, additional dummy tape layers are added to increase the overall thickness and the resulting strength. However, even though five or fewer tape layers are all that is needed, dummy tape layers are needed, which increase the cost and time of fabricating the circuit assembly.

Thus, there are needs for a circuit that does not require typical LTCC dummy layers, and does not require the repetitive firing and lamination steps of a TOS circuit. Without such improvements, circuit boards will continue to be plagued with defects and failures as attempts are made to increase device density and reduce costs.

### DISCLOSURE OF INVENTION

Accordingly, the method of the present invention provides a circuit that does not require typical LTCC dummy layers, and does not require the repetitive firing and lamination steps of a TOS circuit.

Specifically, one solution to the above problems with LTCC and TOS is a method for fabricating a multilayer circuit board that includes juxtaposing a dielectric material against a substrate, with a conductive material in between, subjecting the assembly to only one lamination, and co-firing the entire assembly. A moderating agent, capable of softening and smoothing the dielectric material to assist it in bonding to the substrate, is applied to the substrate prior to laminating the assembly.

As an example, the above method may be completed using two processes performed in parallel. In a first process, a suitable substrate, such as one made from metal, ceramic, or some combination of such materials, like alumina, is used. The substrate may selectively have one layer of patterned conductive material formed thereon followed by a coating of a moderating agent, like pine oil. In a second simultaneous process, at least one green tape layer comprising dielectric material,, for example Dupont GREEN TAPE®, is prepared for combination with the substrate. Each green tape layer has vias formed therein that are filled with conductive material and may selectively have at least one layer of patterned conductive material connected through the vias to any other conductive layers. The dielectric tape layers are juxtaposed against the coating material on the substrate and the whole assembly is laminated together. Lamination is done by applying both a suitable temperature and pressure and maintaining these conditions for a suitable time. Finally, the combined assembly is fired, known as co-fired, to form a circuit board having conductive patterns and vias that substantially conform in position and dimension to a predetermined pattern.

In alternative embodiments of such a method, additional suitable moderating agents, for example, consists of fish oil, ethanol, acetone, MEK, or orange limo line. Additionally, five or fewer dielectric tape layers are included in the un-fired or green assembly; although, any number of tape layers is anticipated on either side or both sides of the substrate.

In summary, a multilayer circuit board is created so that it conforms to its design, and yet does not require the use of dummy layers for sufficient mechanical strength. A circuit board produced from such a method is termed a parallel tape-on-substrate (PTOS) unit.

The foregoing and other features and advantages of the present invention will be apparent from the following more particular description of preferred embodiments of the invention, as illustrated in the accompanying drawings.

### BRIEF DESCRIPTION OF DRAWINGS

Preferred embodiments of the present invention will hereinafter be described in conjunction with the appended drawings, where like designations denote like elements, and:

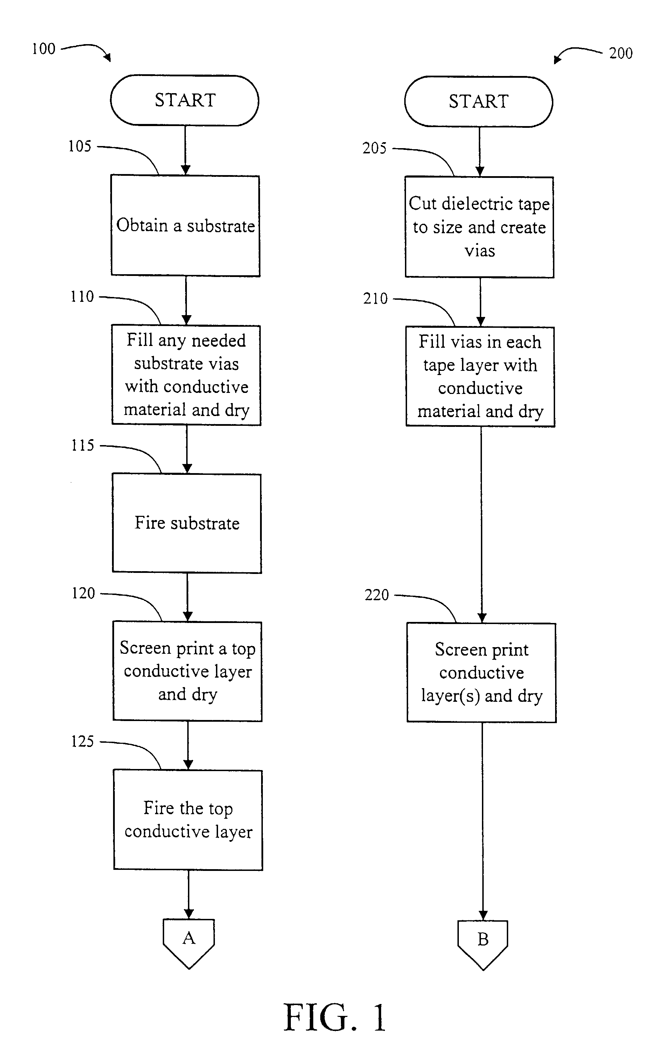

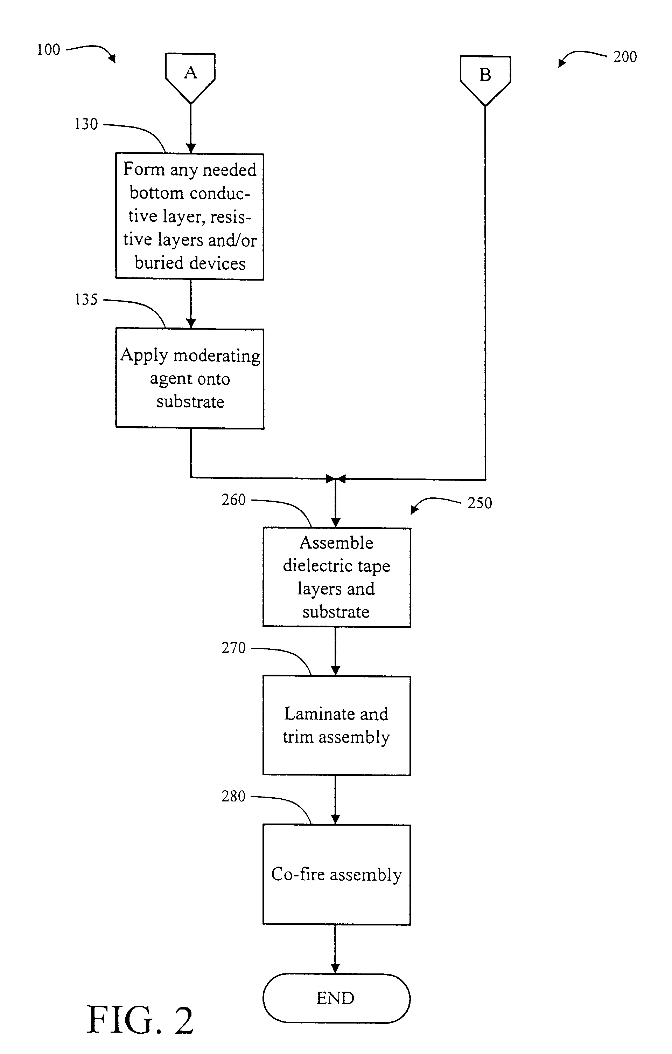

Referring to FIGS. 1 and 2, a schematic diagram of a preferred method is displayed. Particularly, there is illustrated a substrate preparation process 100 and a tape preparation process 200 conducted in parallel. The products from each process are combined in an assembly process 250 to yield a preferred embodiment of a PTOS circuit board according to the present invention.

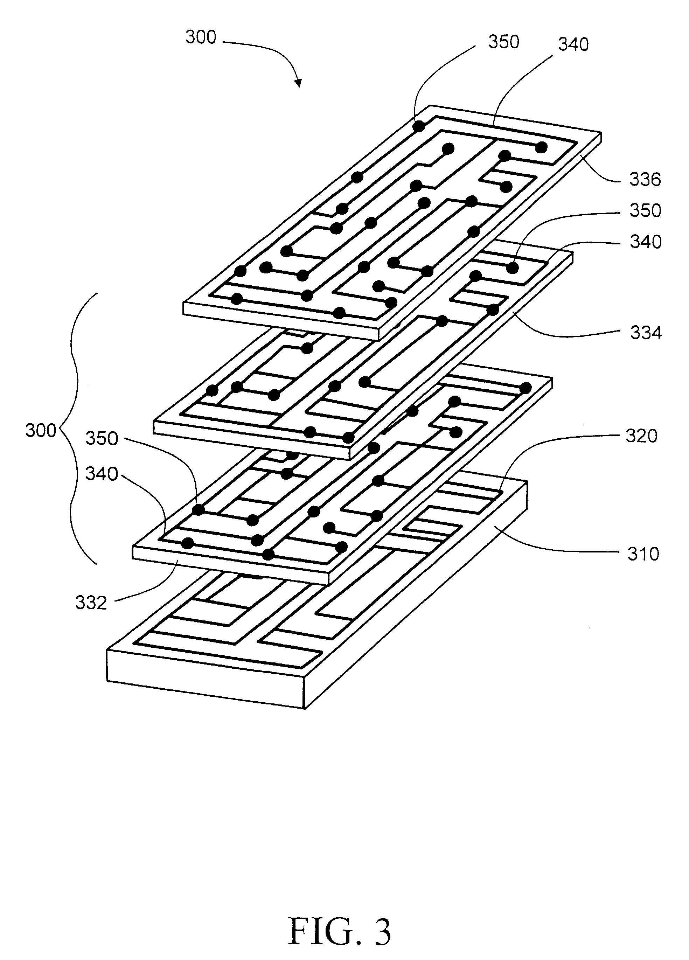

Substrate preparation process 100 comprises steps 105 to 135 and begins with step 105 of obtaining a substrate 310 for preparation, similar to that depicted in FIG. 3. Substrate 310 could comprise a substrate having a wide variety of physical dimensions, structures, and compositions. The selection of a particular substrate largely depends upon the type of application for which a PTOS circuit board is being fabricated. For example, the thickness of substrate 310 and its composition will significantly effect the mechanical strength of the finished circuit board.

One of the problems already discussed regarding LTCC circuits is that any fewer than about five layers of dielectric tape, or about 15 to 25 mils, do not create sufficient mechanical strength. Thus, the need for dummy tape layers has existed for added strength. For the novel PTOS circuit board, no dummy layers are needed, rather, substrate 310 imparts any mechanical strength needed beyond the number of dielectric layers required for any interconnections and devices. Accordingly, one must consider the thickness and strength properties of any dielectric and conductor layers along with the overall desired strength in determining the minimum thickness and composition of substrate 310. For a circuit board of three dielectric layers 330 that is subjected to harmfull heating and cooling cycles or vibrations, a thicker substrate may be required than a circuit board with the same three dielectric layers 330 used in a less harsh environment. A preferred substrate 310 is 96% alumina because it is an industry standard composition suitable for most applications and readily available. A suitable thickness is discussed in the examples below. It is also
FIG. 1 is a schematic diagram of a parallel tape on substrate (PTOS) process according to a preferred embodiment of the present invention;
FIG. 2 is a continuation of the schematic diagram in FIG. 1; and
FIG. 3 is an exploded view of a parallel tape-on-substrate unit fabricated according to the process in FIGS. 1 and 2.

### BEST MODE FOR CARRYING OUT THE INVENTION

According to a preferred embodiment of the present invention, a multilayer circuit board and a method for preparing a parallel tape-on-substrate (PTOS) circuit board are provided. Essentially, the method comprises preparing a support substrate in parallel with preparing green layers of resistant dielectric tape, performing a single lamination of all dielectric layers to the substrate, and co-firing only once. The method is facilitated by a moderating agent, or adhesion promoting means, that softens, smooths, and assists in adhering the resistant dielectric tape to the substrate.

Referring to FIG. 3, an exemplary PTOS green assembly 300 is displayed in an exploded view with three dielectric tape layer 330 and one substrate 310. Dielectric layer 330 includes three dielectric tapes 332, 334, and 336 each preferably formed from a suitable dielectric tape, that is, tape resistant to non-uniform shrinkage during lamination and/or firing. Alternatively, dielectric tapes could be formed from any dielectric tape capable of being prepared and assembled according to the processes discussed below. Dielectric tape most preferably comprises Dupont GREEN TAPE™ 951AT available from E. I. Du Pont de Nemours and Co. in Wilmington, DE. Each dielectric tape may have vias 350 formed therethrough, which are filled with suitable conductive material. Both the substrate 310 and tape layer 330 may have patterned conductive layers 320 and 340 that would be interconnected by vias 350.
important to consider the thermal expansion coefficient of substrate 310. If the coefficient of substrate 310 is too disparate from the coefficient of dielectric layers 330, then cracking may occur upon cooling after the firing step described below.

If a dielectric layer 330 is to be placed on both sides of substrate 310, then typically vias are provided in substrate 310 to connect conductive layers 320 on both sides during step 110. Additionally, certain devices to be formed in a PTOS circuit board or external connections to the circuit board may require filled vias in substrate 310. Once any needed vias are filled, the conductive material is dried at the necessary process conditions, depending on the fill composition and amount. Typically, drying takes place at approximately 50 to 150 °C for about 5 to 30 minutes. Thereafter, step 115 is completed to fire the substrate, causing a transformation of what is typically a conductive ink to form conductors through the vias. Typically, thick film is fired at 850° C with 10 minutes at the peak temperature.

Next, step 120 occurs wherein a patterned conductive layer 320 is formed on substrate 310 if needed. Layer 320 may be formed by any conventional approach, though preferably by screen printing a conventional conductive material capable of forming a completed conductive layer after firing, as in step 125. After firing, any additional structures, not illustrated, are formed in step 130 as needed, such as a bottom conductive layer on the opposite side of substrate 310, or passive components like resistive layers for features such as resistors, etc., which then become buried devices once the tape layer 330 is placed thereover.

Finally, a moderating agent is applied to substrate 310 in step 135 to prepare it for attachment to the dielectric tape layer 332. A preferred moderating agent softens, smooths, and otherwise assists in adherence of dielectric tape 332 to substrate 310. However, a more preferred moderating agent may also possess a viscosity and surface properties conducive to spin coating. Presently, spin coating appears the most suitable method for applying a thin layer of moderating agent at a uniform thickness to the entire surface area of substrate 310 that will be in contact with dielectric tape 330. In the event that another method is used for applying the moderating agent, like spraying, then the viscosity and the surface properties may or may not need to be conducive to spin coating.

In an alternative embodiment, depending on how patterned conductive layers 340 are formed on dielectric tape layers 332, 334 and 336, it is conceivable that no conductive layer 320 is needed on substrate 310. For example, conductive layers 340 may be formed on dielectric tape 332 and then tape layers 330 is flipped over to juxtapose conductive layer 340 on tape 336 against substrate 310. Next, the assembly would again be flipped over so that vias through tape layer 332 would be coupled, maybe by a ball grid array, to bond pads on a desired location on a circuit board.

As shown in FIGS. 1 and 2, tape layer 330 preparation process 200 occurs parallel to substrate preparation process 100 and comprises steps 205 to 220. Step 205 includes cutting dielectric tape layers 332, 334 and 336 to size and creating vias 350 therethrough, unless vias are already present, as with pre-punched tape. Some allowance may be given to account for shrinkage as to the size of dielectric tape 330 and location of vias 350. It may also be desirable to cut dielectric tape 330 somewhat larger than substrate 310 and then trim excess material in a later step. Along with cutting dielectric 310, a MYLAR® (polyester film) sheet (not shown) with a silicone coating is often placed on one side of the tape to increase the robustness of the green tape. Thus, the polyester film is often cut to size for protecting the dielectric tape layer, and may be left on the top layer 336 during lamination, described below, to assist in reducing defects. Next, step 210 involves filling vias 350 in dielectric tape layers 332, 334 and 336 with conductive material and drying in a similar fashion to step 110 discussed above for preparing substrate 310. Finally, step 220 involves applying a patterned conductive layer 320, if needed, to each dielectric tape layer in a similar fashion similar to step 120 discussed above for preparing substrate 310. It is conceivable that no conductive layer 340 is needed on a particular dielectric tape layer. For example, there are circuits that only require vias on the top tape layer 336.

As shown in FIG. 2, once substrate 310 and dielectric tape layers 330 are prepared, assembly process 250 may proceed to complete a PTOS unit. In step 260, for example MYLAR® (not shown), dielectric tape layers 330, and moderating agent coated substrate 310 are stacked or assembled between steel plates preparatory to lamination. It is noted that the silicon coating on the MYLAR® is juxtaposed against the top dielectric tape layer 330 and the steel plate is in turn juxtaposed against the MYLAR®, as a protection for the top layer. In step 270, the assembly is laminated by applying a suitable pressure at a low temperature (around 50° C) and for a suitable time followed by trimming the assembly to the desired size; typically to the same size as substrate 310. The purpose of step 270 is to register or align each layer in its correct position with respect to substrate 310 and the other layers, and to at least partially form bonds between layers 330 and substrate 310 from the application of the low heat and pressure. Finally, the laminated green assembly 300 is co-fired in step 280 to fully form such bonds, to drive-off or evaporate organic compounds from the materials forming green assembly 300, and to yield a PTOS unit. A co-fire step is about the same as the previous fire steps except that several parts are fired together, ie. the substrate 310 and tape layers 330 are cooperatively fired. Following step 280, other steps (not shown) may be taken to prepare the PTOS unit for actual use as a circuit board, such as adding other electronic components and/or connections.

In conventional TOS processes, dielectric tape is used that includes plasticizer, binders, or other components sufficient for a bond to form between the tape and the substrate. Because the tape is applied one layer at a time in conventional TOS and the patterned conductive layer is applied after firing of the dielectric. However, applying one layer at a time requires a relatively high processing time and cost. The dielectric tapes used in conventional TOS processes could be used in a parallel tape-on-substrate (PTOS) process described above. Unfortunately, the volatile components of such tapes often contribute to misalignment due to shrinkage, primarily during drying, but perhaps during lamination too. Accordingly, a preferred embodiment of the present invention provides a moderating agent that assists the use of dielectric tape during lamination and co-firing. Specifically, Dupont GREEN TAPE™ 951AT is a best mode that is suitable for such a tape.

Designed for use in LTCC applications, Dupont GREEN TAPE™ 951AT and its accompanying system of conductive materials was designed to overcome the problems of LTCC. GREEN TAPE™ shrinks about 11% to 12% in LTCC because it is not adhered to a substrate as in a TOS process. Unfortunately, a side effect of volatile compounds, as in GREEN TAPE™, is that such dielectric tape loses the ability to adhere to some materials. Since a multilayer ceramic is desired in LTCC, it is important to balance the volatile composition with the need for each dielectric layer to adhere to adjacent dielectric layers. Enough plasticizer and/or binder must be present with sufficient volatile compounds for a bond to form between dielectric layers in LTCC. If the layers are not sufficiently bonded, LTCC circuit will fail for lack of proper layer-to-layer bonding. Such a balance of volatile composition has been attained in some dielectric tapes for LTCC such as GREEN TAPE™, however, such tapes will not properly adhere to a metal ceramic substrate, like alumina, when used in a PTOS.

Since a PTOS process, according to a preferred embodiment, may use a dielectric tape layer that does not easily attached to a ceramic based substrate, a moderating agent is needed in assisting formation of a bond between such dielectric tape layer 332 and substrate 310. It may be possible to design a dielectric material for tape layer 332 that has just enough volatile compounds in the plasticizer and/or binder to adhere to substrate 310. However, GREEN TAPE™ is widely used in LTCC applications and is very cost competitive with conventional tapes. Accordingly, GREEN TAPE™ or similar dielectric tape is preferred in the present invention because of its cost advantage, wide acceptance, and minimized differential shrinkage. Nevertheless, GREEN TAPE™ or similar dielectric tape will likely need assistance from a moderating agent, according to a preferred embodiment, to properly adhere to substrate 310.

A suitable moderating agent possesses chemical and/or physical properties that allow it to soften and/or smooth dielectric tape layer 330. It is preferable that the effect occur when tape layer 330 is juxtaposed against a uniform coating of moderating agent on substrate 310 as in step 260 above. It can be said that a moderating agent acts somewhat as a solvent. In this sense, the moderating agent modifies the plasticizer and/or binder near the surface of dielectric tape layer 330 so that tape layer 330 conforms better to the surface of substrate 310, improving the bond between them. Thus, tape layer 330 behaves more like a conventional tape-on-substrate dielectric material as to bonding capability. Depending on the composition of the tape layer 330, various substances may be selected for use as a moderating agent. For GREEN TAPE™, pine oil is a preferred moderating agent. The pine oil is most preferably mixed in equal parts with toluene, primarily to allow spin coating on substrate 310. Other suitable moderating agents for GREEN TAPE™ is fish oil, ethanol, acetone, MEK (methyl Ethyl Ketone), or orange limoline, and many others that one skilled in the art would understand from the disclosure to achieve the desired results. Such compounds are only considered moderating agents, rather than adhesives or bonding layer materials, because they dissipate or burn off during PTOS processing and are not apparent in the final circuit board. By contrast, an adhesive or bonding layer actually forms a new layer of material in a circuit board and may effect its performance.

Once dielectric tape layers 330 bonds to substrate 310 during lamination and subsequent co-firing, little shrinkage generally occurs in the x-y dimension as a result of the surface tension in the bond between tape layers 330 and a non-shrinking substrate 310. Instead only z dimension shrinkage occurs, however, a level of residual stress exists in a completed PTOS unit that depends on the number of dielectric layers 330 in the unit. Often, the residual stress is at least partially relieved in a one-sided PTOS circuit board by bowing to compensate for shrinkage prevented by the tape-substrate bond. Accordingly, the bowing is more pronounced for PTOS units with high coefficient of thermal expansion differences between the substrate and tape. Typically, five or fewer layers will not produce significant bowing and it may also be possible to offset any bowing by placing dielectric layers 330 on both sides of substrate 310.

### EXAMPLE 1

A circuit board was prepared by a parallel tape-on-substrate method according to a preferred embodiment of the present invention. A 10.2 cm x 10.2 cm (4 in. x 4 in. ) substrate of 96% alumina having a thickness of 0.64 mm (25 mil) was placed in a spin coater. A 50/50 pine oil/toluene mixture was manually spread over the substrate surface and then spun for 10 sec. at 1400 rpm. The resulting coating had a weight of about 0.05 g and a wet film thickness of about 7 µm. In parallel with preparing the substrate, Dupont GREEN TAPE™ 951AT having a thickness of 0.11 mm (4.5 mil) was preconditioned by curing at 120°C for 30 min. then sitting at room temperature for 12 hours. One piece of MYLAR® coated on one side with silicone and two pieces of GREEN TAPE™ were cut to a dimension somewhat larger than the substrate. The prepared substrate was placed coated side up on a 15.2 cm x 15.2 cm (6 in. x 6 in.) steel plate. The first piece of GREEN TAPE™ was placed shiny side down on the substrate and gently pressed against the substrate. The second piece of GREEN TAPE™ was then placed shiny side down on the first piece and gently pressed against the first piece. The piece of MYLAR® was placed silicone side down on the second piece of GREEN TAPE™. A second steel plate was placed on top of the MYLAR® and the assembly was laminated in a lamination press at 27,600 kPa (4000 psi) and 50°C for 1 min. then rotated 180° and laminated at the same conditions for 1 min. again. The laminate was removed from the steel plates and excess GREEN TAPE™ trimmed around the edges of the substrate. The laminate was then fired at the manufacturers suggested profile, ie. 850° C with 30 minutes at peak temperature.

Accordingly then, a preferred PTOS process efficiently executes process steps by preparing substrate 310 and dielectric tape layer 330 in parallel, performing a single lamination of all dielectric layers to the substrate, and co-firing only once. Preferred PTOS process also yields a mechanically strong circuit board even for fewer than about five dielectric tape layers 330 with its use of substrate 310. Further, preferred PTOS also provides a moderating agent for assisting adherence of dielectric tape layer 332 to substrate 310 when needed.

While the invention has been particularly shown and described with reference to preferred embodiments thereof, it will be understood by those skilled in the art that various changes in form and details may be made therein without departing from the scope of the invention. Accordingly, unless otherwise specified, any dimensions of the apparatus or any sequence of steps indicated in the drawings or herein are given as an example and not as a limitation.

## Claims

1. A method of fabricating a multilayer circuit board, comprising forming an assembly comprising at least one layer of dielectric material with a layer of patterned conducting material thereon;
placing the assembly on to a substrate with an adhesion promoting material between the dielectric material of the assembly and the substrate; and
firing the substrate with the assembly thereon to yield a circuit board.

2. A method according to Claim 1, comprising subjecting the substrate, conductive material, and dielectric material to a single, simultaneous lamination process.

3. A method according to Claim 1 or 2, comprising forming the assembly with more than one layer of dielectric material, each layer having one layer of patterned conductive material placed thereon.

4. A method according to Claim 1, 2 or 3, wherein the adhesion promoting material is a moderating agent.

5. A method according to Claim 4, wherein the moderating agent comprises pine oil or a mixture of pine oil and toluene.

6. A method according to Claim 4, wherein the moderating agent comprises fish oil, ethanol, acetone, methyl ethyl ketone, or orange limo line.

7. A method according to any preceding claim, comprising applying adhesion promoting material to the substrate by spin coating.

8. A method according to any preceding claim, wherein the substrate is a ceramic or ceramic-on-metal substrate.

9. A method according to any preceding claim, wherein the step of forming the assembly comprises providing one to five layers of dielectric material, each layer having one layer of patterned conductive material thereon.

10. A method for fabricating a multilayer circuit board, comprising the steps of:
a) providing a substrate;
b) providing at least one layer of dielectric material selectively having at least one layer of patterned conductive material placed thereon;
c) juxtaposing the at least one dielectric layer against the substrate to form an assembly;
d) subjecting the assembly to only one lamination; and
e) co-firing the assembly to yield a circuit board.
